# EUROPEAN PATENT SPECIFICATION

(11) **EP 0 475 223 B1**
(45) Date of publication and mention of the grant of the patent: **22.10.1997**
(21) Application number: 91114675.1
(22) Date of filing: 30.08.1991
(51) Int. Cl.: H01L 21/60, H01L 25/065

(54) **Method of fabricating integrated circuit chip package**
Herstellungsverfahren für integrierte Schaltungschip Packung
Procédé de fabrication d'un empagnetage de puce à circuit intégré

(30) Priority: 31.08.1990 JP 230418/90
(43) Date of publication of application: 18.03.1992
(73) Proprietor: NEC CORPORATION, Tokyo (JP)
(72) Inventor: Kusaka, Teruo, c/o NEC Corporation, Minato-ku, Tokyo (JP)
(74) Representative: Glawe, Delfs, Moll & Partner

(56) References cited:
- EP-A- 270 067
- EP-A- 0 321 238
- 1990 SYMPOSIUM ON VLSI TECHNOLOGY, Digest on Technical Papers, 4th - 7th June 1990, Honolulu, pages 95-96; Y. HAYASHI et al.: "Fabrication of three- dimensional IC using "Cumulatively Bonded IC" (CUBIC) technology"
- PATENT ABSTRACTS OF JAPAN, vol. 14, no. 441 (E-981) 20th September 1990; & JP-A-2 174 153
- PATENT ABSTRACTS OF JAPAN, vol. 12, no. 314 (E-649) 25th August 1988; & JP-A-63 080 542
- PATENT ABSTRACTS OF JAPAN,vol. 12, no. 402 (E-673) 25th October 1988; & JP-A-63 141 356
- PATENT ABSTRACTS OF JAPAN, vol. 14, no. 156 (E-908) 26th March 1990; & JP-A-2 014 536

## Description

### Background of the Invention

The present invention relates to a method of fabricating an integrated circuit (IC) chip package and, particularly, to a method of fabricating a multi-chip module using flip-chip bonding technique (interconnection).

As means for increasing electronic circuit density, a printed-circuit board (PCB) has been used heretofore. A number of IC devices (including LSIs, VLSIs), together with other circuit elements and interconnections between such IC devices and circuit elements, are mounted on a PCB and connections to external circuits are realized by printed wirings on the PCB and/or connectors provided thereon. Each of such IC devices is provided as a single chip package which contains a single IC chip which is usually sealed. Therefore, in order to increase the electronic circuit density on a PCB, it is necessary to increase the wiring density on the PCB so that a larger number of single chip IC devices can be mounted on the PCB. However, since respective IC devices have certain size and the wirings have certain width, it is impossible to increase the circuit density of the PCB beyond a certain limit. Therefore; it is difficult to make a PCB-based device sufficiently compact. Further, in the PCB-based device, it is difficult to dissipate heat generated in respective IC devices. Further, since it is difficult to shorten signal paths within the device, an upper limit of signal bit rate capable of being processed in that device is low.

As means for solving these problems, a multi-chip IC package has been proposed, which comprises a ceramic substrate having a multi-layered wiring and a plurality of IC chips mounted thereon and connected to the wiring. In such ceramic substrate-based multi-chip package, the requirements of compactness, improved reliability and shortened signal path can be achieved. However, the problem of heat dissipation can not be fully solved due to low thermal conductivity of the ceramic substrate. In addition to this, a problem of destruction of IC chips occur due to difference in thermal expansion between the IC chips and the ceramic substrate.

In view of these difficulties of the ceramic substrate, the use of silicon substrate rather than the ceramic substrate has been proposed. Silicon wiring substrate has heat conductivity high enough to solve the problem of heat dissipation and hence the problem of thermal expansion difference. In addition to this effect, the use of silicon substrate is advantageous since the state-of-art technique for fabricating IC chip which includes lithography technique, inter-layer wiring technique, etc., can be directly used for processing of the silicon circuit substrate. Further, since respective IC chips to be mounted on the silicon circuit substrate such that the multi-chip scheme is realized may be tested after their diffusion processes, the reliability of a final multi-chip assembled as a multi-chip module becomes high accordingly. Further, IC chips to be mounted on the circuit board can be flexibly combined. For example, a combination of MOS IC chip and bipolar IC chip, a combination of MOS IC chip and compound semiconductor IC chip, etc., may be possible. (The above-mentioned prior arts are disclosed in John K. Hagge, "Ultra-Reliable Packaging for Silicon-on-Silicon WSI", IEEE Transactions on Components, Hybrids, and Manufacturing Technology, Vol. 12, No. 2 (June 1989), P. 170 to 179.)

In order to effectively dissipate heat, it is usual to attach such member as heat sink intimately onto a surface of a silicon circuit board which is opposite to that on which IC chips are mounted, by means of suitable adhesive. With this construction, heat produced in a plurality of IC chips is transmitted through the silicon circuit board to the heat sink, resulting in insufficient heat dissipation. Particularly, in a multi-chip module having a structure in which a gap is left as it is between the IC chips and the silicon circuit board, heat dissipation effect is usually insufficient.

A module construction in which a plurality of IC chips are mounted on a silicon circuit board through flip-chip interconnection in face-down configuration and heat sink member is intimately attached to a rear surface of the chip may be optimum for heat dissipation. However, in order to assure the heat dissipation effect, it is necessary that the rear surfaces of the IC chips mounted on the silicon circuit board in face-down manner are coplanar and the intimate contact of the respective rear surfaces of the IC chips with the heat sink is maintained. That is, it is necessary that the respective IC chips are fixed on the silicon circuit board with uniform gap in thickness direction. However, when the gap in thickness direction varies by such as tilting of chips, etc., there may be a gap left between the heat sink member and the IC chips, resulting in degraded thermal conduction therebetween and hence degraded heat dissipation.

The arrangement of the plurality of IC chips fixed on the silicon circuit board with uniform gap therebetween in thickness direction is usually realized by using metal bumps provided on either or both of the IC chips and the circuit board for interconnection of the flip-chip. According to the method disclosed in, for example, Japanese Kokai (P) 63-141356 published on June 13, 1988, metal bumps each of Cu or Au whose height is larger than a thickness of a surface insulating film of SiO₂ or SiN formed on an IC chip are formed. On the other hand, the insulating film is formed with holes at positions corresponding to these bumps and solder of Sn, Pb and In, etc., is disposed in each of the holes. The solder is melted when the holes and the bumps are mated with each other, so that the IC chips are fixed to the silicon circuit board. The metal bumps substantially define the gap between the IC chips and the silicon circuit board and the solder contributes to finely regulate the gap.

A technique in which electric connection between IC chips and a silicon circuit board is performed by using not solder but shrinking effect of photo-polymerizing resin with light illumination is proposed (cf. R. Harada et al., "Applications of New Assembly Method "Micro Bump Bonding Method"", International Electronic Manufacturing Technology symposium, from P. 47). In this technique, a gap between the IC chip and the silicon circuit board is mainly determined by a sum of heights of metal bumps of Au provided on both the IC chip and the silicon circuit board and the photo-polymerizing resin is used such that the metal bumps are reliably connected electrically when the bumps are mated with each other. As is clear from this construction, it is impossible to finely regulate the gap between the chip and the circuit board after the adhesive resin is photo-polymerized.

The technique disclosed in the above-mentioned Japanese Kokai is advantageous over other prior art techniques in that the gap between the IC chip and the silicon circuit board can be regulated finely by means of the solder disposed in the holes of the surface insulating film. However, it still have a disadvantage that, when the metal bumps of the IC chips are fitted in the holes of the insulating film on the silicon circuit board, a hollow cylindrical gap defined by level of molten solder, side wall of the hole and a bottom portion of the metal bump is formed in each hole. Air enclosed in these cylindrical gaps may expand by temperature increase after assembling of a multi-chip module, deforming the members defining the space or, in the worst case, destroying a portion of these members. In the conventional technique using solder, the connection and fixing of the IC chips are performed in a single step and, after fixed, it is difficult to selectively replace defective IC chip or chips with new one or ones when such defect is detected.

VLSI Technical Symposium pages 95 to 96, 4th to 7th June 1990 discloses a metal stud-solder bump method of attaching a semicoductor device to a semiconductor circuit board using a resinous bonding agent.

EP-A-270 067 discloses a method for making a semiconductor device comprising first and second semiconductor circuit units, in which a plurality of connecting electrodes are formed on an upper surface and an electric insulating layer is formed about the entire surface of at least two substrates.

### Brief Summary of the Invention

Therefore, an object of the present invention is to provide a method of fabricating a multi-chip module having a plurality of IC chips mounted on a silicon circuit board through flip-chip interconnection, by which gap between the IC chips and the circuit board in its thickness direction can be regulated without forming such air space.

Another object of the present invention is to provide a method of fabricating a multi-chip module having a plurality of IC chips mounted on a silicon circuit board through flip-chip interconnection, in which electric characteristics of the module is checked in a state where the IC chips are temporarily fixed to detect defective chips and, after defective chips are replaced by new ones, all of the IC chips can be fixed to the circuit board permanently.

These objects are solved by the features of claim 1.

In the present invention, the organic insulating material forming the first film and the second film may be of thermoset polyimide and the adhesive in the painting step may be of polyimide before thermosetting.

Further, in the present invention, the thickness of the first film may be smaller than the second film.

The step of filling the through-holes with the solder metal may comprise a first step of filling the through-holes with relatively high melting point metal and a second step of filling the through-holes with relatively low melting point metal.

Further, a sum of thicknesses of the first film and the second film may be larger than a height of the metal bumps.

The present method may further comprises the step of disposing on surfaces of the IC chips opposite to the one surfaces thereof heat sink members with surfaces of the heat sink members being in intimate contact with the opposite surfaces of the IC chips.

In the present invention, the step of melting solder metal includes a pre-heating step of melting the low melting point metal and a main heating step of melting the high melting pint metal so that, after the pre-heating step completes, the multi-chip module can be checked on electrical connection thereof.

### Brief Description of the Drawings

The above-mentioned and other objects, features and advantages of the present invention will become more apparent by reference to the following detailed description of the present invention taken in conjunction with the accompanying drawings, wherein:
Fig. 1 a longitudinal cross section of an IC multi-chip package for explaining an embodiment of the present invention;
Figs. 2A to 2C shows portions of Fig. 1 in expanded scale to explain certain steps of the method according to the present invention, respectively; and
Figs. 3A and 3B are a plan view of an IC chip to be mounted on a silicon circuit board of a multi-chip module and a cross section taken along a line A-A in Fig. 3A, respectively.

### Detailed Description of the Preferred Embodiments

An embodiment to be described subsequently is directed to a multi-chip module equipped with three microprocessors each designed for an engineering work station (EWS) for high rate data processing. It should be noted, however, that the fabricating method according to the present invention can be applied to other multi-chip modules for general use.

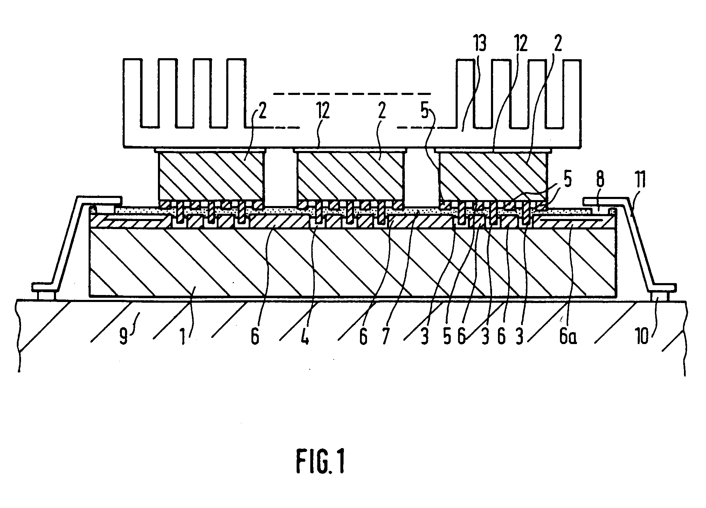

Referring to Fig. 1 showing a longitudinal cross section of an IC multi-chip module fabricated according to the present invention, the module comprises a silicon circuit board 1, three IC chips 2 mounted on a surface of the circuit board 1 according to face-down scheme and a heat dissipation fin 13 mounted on rear surfaces of the IC chips 2 through thermal grease 12. Connecting pads 8 are formed on a peripheral portion of the circuit board 1 for electrical connection through lead wires 11 for TAB (Tape Automated Bonding) to connecting pads 10 on a PCB 9 on which the module is to be mounted.

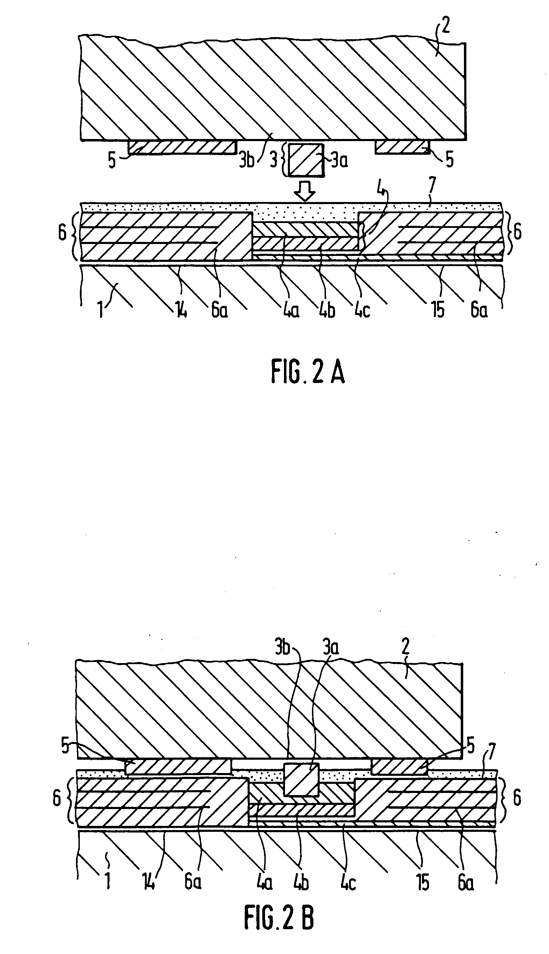

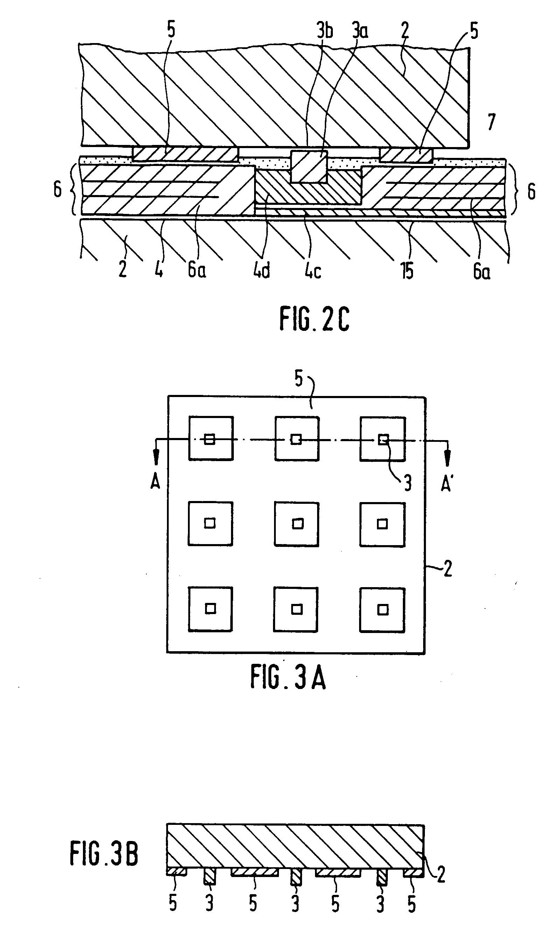

Referring to Figs. 2A to 2C showing one of the three IC chips 2, the IC chip 2 is a complete microprocessor chip obtained through predetermined steps including such as diffusion. On a front surface of the IC chip 2, an organic insulating film 5 having a first thickness is formed and patterned by selective etching with a photo-resist film to form through-holes at desired positions. In each of these through-holes, a metal layer 3b of titanium (Ti) or chromium (Cr), etc., is formed to a thickness of 0.1 to 0.3 µm by vapor deposition and further a metal layer 3a of gold (Au) or copper (Cu), etc., is formed thereon. In this step, the film 5 is formed by spin-coating the IC chip surface with liquid polyimide and thermosetting it by heating it to a temperature of 400°C to 450°C. The thickness of the film 5, that is, the first thickness is selected as 5 µm The structure of the IC chip 2 is shown in plan view in Fig. 3A and in cross section taken along a line A-A in Fig. 3A in Fig. 33. That is, air releaf paths are provided in the film 5.

Returning to Fig. 2, on a surface of the silicon circuit board 1, an inorganic insulating film 14 of silicon dioxide (SiO₂) or a mixture of silicon dioxide and silicon nitride (SiN) is formed to a thickness of 0.5 µm to 2.0 µm through oxidation step or vapor deposition step and, on the film 14, a suitably patterned substrate wiring layer 15 of copper (Cu), gold (Au) or aluminum (Al) is formed. Further, an organic insulating film 6 having a second thickness and including a multi-layered wiring 6a composed of three to five wiring layers (only two layers are shown in Fig. 2 for simplicity of illustration) is formed on the wiring layer 15 and the film 14. The organic insulating film 6 is formed by laminating wiring layers of copper (Cu), gold (Au) or aluminum (Al) with using polyimide layers each having thickness of 15 to 29 µm and formed by spin coating as in the case of the film 5 on the chip 2 as interlayer insulating films and heating the alternating lamination of the wiring layers and the polyimide layers to thermoset polyimide.

A square through-hole having each side of 30 to 100 µm is formed in the insulating film 6 at a predetermined position, that is, a position corresponding to the metal bump 3 of the IC chip by using a similar step to that used in forming the through-hole of the film 5 and filled with solder metal 4. The solder metal 4 includes a thin base layer 4c of nickel (Ni) formed on the substrate wiring layer 15 by direct plating, a high melting point metal layer 4b of relatively high melting point metal such as gold-silicon (Au-Si) alloy or lead-tin alloy (95%Pb/5%Sn) formed on the base layer 4c and a low melting point metal layer 4a of indium (In) or eutectic solder, etc., formed on the layer 4b.

After the above-mentioned processings are performed with respect to the IC chips 2 and the silicon circuit board 1, either or both of the films 5 and 6 are painted uniformly with liquid polyimide to form thin polyimide film, then the IC chips 2 are pressed to the silicon circuit board 1 with the metal bumps 3 being mated with the solder metal 4 to form a semi-assembly and, thereafter, the semi-assembly is heated to a temperature slightly above a melting point of the solder metal layer 4a and lower than the melting point of the solder metal layer 4b. In this step, a plurality of test probes (not shown) of a measuring device are connected to the connecting pads 8 to check electrical connections between the IC chips 2 and the circuit board 1. When it is determined, as a result of the this check, that the connection between certain one of the IC chips 2 and the silicon circuit board 1 is out of a predetermined state, the certain IC chip 2 may be replaced with a new chip. When the check shows that all of the IC chips 2 are in correct connection states, the semi-assembly is further heated to a temperature above the melting point of the solder metal layer 4b while keeping the press contact of the IC chips 2 with the silicon circuit board 1 to thermoset the adhesive resin 7 of the thin polyimide layers and to make the electric connection between the solder metal 4 and the metal bump 3 complete (at this time, the solder metal layers 4a and 4b are melted together to form a single solder metal layer 4d).

In order to avoid formation of closed space around the metal bump 3 by the side walls of the through-holes of the films 5 and 6 in the above-mentioned pressure contact and heating steps, these through-holes have discontinuous walls (not shown) at least in the vicinity of each of them in a circular or square peripheral direction around an axis of the metal bump 3. With this construction, the problem occurring when air is left in the closed space, that is, the problem that constitutional components of a multi-chip package are deformed due to temperature variation after it is assembled, can be prevented from occurring.

Instead of the fin of the IC multi-chip package shown in Fig. 1, it is possible to adhere a heat radiator block, which may be of stainless steel, has cooling channels through which cooling water flows and exhibits superior cooling effect, to the IC chips through thermal grease.

As described hereinbefore, in the present invention, a distance between the IC chips and the silicon circuit board is defined by thicknesses of the organic insulating films formed on the IC chip side and the circuit board side, respectively to obtain a uniformity of the gap therebetween. That is, since the height of the metal bump is selected as being smaller than a sum of the thicknesses of these films and the through-holes of these films have discontinuous walls (not shown) at least in the vicinity of each of them in a circular or square peripheral direction around an axis of the metal bump, the space around the metal bump never be sealed. Further, since the organic insulating film on the side of the circuit board is made thicker to give a large space for melted solder in the through-hole thereof, it is possible to fill the space around the metal bump with a sufficient amount of melted solder when it is dipped therein. Thus, the formation of closed space in the organic insulating film due to melting of solder for connection of the metal bump is avoided. Further, it is possible to form the solder as a double layer structure of a relatively low melting point metal and a high melting point metal and perform electric connection test during the pre-heating step for melting the low melting point metal.

## Claims

1. A method of fabricating an integrated circuit chip package forming a multi-chip module including the steps of electrically connecting a plurality of IC chips (2) to a single, flat silicon circuit board (1) in a manner of flip-chip interconnection, said IC chips (2) each having a plurality of impurity diffusion regions at a front surface thereof and a plurality of metal bumps (3) respectively connected to said impurity diffusion regions at said front surface thereof, said single flat silicon circuit board (1) having a wiring pattern (15, 6a), said method comprising the steps of:
forming a first flat film (5) of an organic insulating material on said front surface of said IC chips (2) up to a first thickness;
forming a plurality of first through-holes (3b) in said first flat film (5), forming a plurality of air release paths being elongated from said plurality of first through-holes (3b) to an end portion of said first flat film (5), said through holes thereby having discontinuous walls and forming said metal bumps (3) disposed within said through-holes;
forming a second flat film (6) of an organic insulating material on a surface of said single flat silicon circuit board (1) up to a second thickness;
forming a plurality of second through-holes (4) in said second flat film (6);
filling said plurality of second through-holes (4) with solder metal (4a, 4b, 4c), respectively;
forming adhesive of thermosetting organic insulating material (7) on the facing surface of said first (5) and/or said second flat film (6); and
heating said single flat silicon circuit board (1) with mating said metal bumps (3) formed in said plurality of first through-holes and said solder metal formed in said plurality of second through-holes (4) to melt said solder metal and thermoset said adhesive of thermosetting organic insulating material.

2. The method claimed in claim 1, wherein said organic insulating material forming said first film (5) and said second film (6) is thermoset polyimide and said adhesive is polyimide before thermosetting.

3. The method claimed in claim 2, wherein said first film (5) is thinner than said second film (6).

4. The method claimed in claim 1 or 2, wherein said step of filling said second through-holes (4) with said solder metal comprises a first step of filling said through-holes (4) with relatively high melting point metal and a second step of filling said through-holes (4) with relatively low melting point metal.

5. The method claimed in claim 1 or 2, wherein a sum of thicknesses of said first film (5) and said second film (6) is larger than the height of said metal bumps.

6. The method claimed in claim 1 or 2, further comprising the step of disposing on surfaces of said IC chips (2) opposite to said front surfaces thereof a heat sink member (13) with a surface of said heat sink member being in intimate contact with said opposite surfaces of said IC chips (2).

7. The method claimed in claim 6, further comprising, before the step of disposing, the step of painting said opposite surfaces with thermal grease.

8. The method claimed in claim 4, wherein the heating step comprises a pre-heating step of melting said low melting point metal and a main heating step of melting said high melting point metal so that, after the pre-heating step completes, said multi-chip module can be checked on electrical connection thereof.

## Patentansprüche

1. Verfahren zur Herstellung einer integrierten Schaltungschippackung, die ein Multichipmodul bildet, mit den Schritten:
elektrisches Verbinden einer Vielzahl von IC-Chips (2) auf einer einzelnen flachen Siliziumschaltkreisplatine in Form einer Flip-Chip-Zwischenverbindung, wobei die IC-Chips (2) jeweils eine Vielzahl von Verunreinigungs-Diffusionsbereichen an ihrer Vorderfläche haben und eine Vielzahl von Metallanschlüssen (3), die jeweils mit den Verunreinigungsdiffusionsbereichen an der Vorderfläche verbunden sind, wobei die einzelne flache Siliziumschaltkreisplatine (1) ein Verdrahtungsmuster (15, 6a) aufweist, wobei das Verfahren die Schritte aufweist:
Ausbilden eines ersten flachen Films (5) eines organischen Isolationsmaterials auf der Vorderfläche des IC-Chips (2) bis zu einer ersten Dicke;
Ausbilden einer Vielzahl von ersten Durchgangslöchern (3b) in dem ersten flachen Film (5),
Ausbilden einer Vielzahl von Luftablaßpfaden, die sich von der Vielzahl von ersten Durchgangslöchern (3b) zu einem Endteil des ersten flachen Films (5) erstrecken, wodurch die Durchgangslöcher diskontinuierliche Wandungen haben, und Ausbilden der Metallanschlüsse (3) in den Durchgangslöchern;
Ausbilden eines zweiten flachen Films (6) aus organischem Isolationsmaterial auf der Oberfläche der einzelnen flachen Siliziumschaltkreisplatine (1) bis zu einer zweiten Dicke; Ausbilden einer Vielzahl von zweiten Durchgangslöchern (4) in dem zweiten flachen Film (6);
Ausfüllen der Vielzahl von zweiten Durchgangslöchern (4) jeweils mit Lötmaterial (4a, 4b, 4c);
Ausbilden eines Klebers aus aushärtbarem organischen Isolationsmaterial (7) auf der Oberfläche des ersten (5) und/oder des zweiten flachen Films (6); und
Aufheizen der einzelnen flachen Siliziumschaltkreisplatine (1) unter Anpassung der Metallanschlüsse (3) ausgebildet in der Vielzahl der ersten Durchgangslöcher und des Lötmaterials, das in der Vielzahl der zweiten Durchgangslöcher (4) ausgebildet ist, um das Lötmetall zu schmelzen und den Kleber aus aushärtbarem organischen Isolationsmaterial auszuhärten.

2. Verfahren zur Herstellung einer integrierten Schaltungschippackung nach Anspruch 1,
wobei das organische Isolationsmaterial, das den ersten Film (5) und den zweiten Film (6) bildet, ein aushärtbares Polyimid ist und der Kleber vor dem Aushärten ein Polyimid ist.

3. Verfahren zur Herstellung einer integrierten Schaltungschippackung nach Anspruch 2,
wobei der erste Film (5) dünner ist als der zweite Film (6).

4. Verfahren zur Herstellung einer integrierten Schaltungschippackung nach Anspruch 1 oder 2,
wobei der Schritt des Ausfüllens der zweiten Durchgangslöcher (4) mit dem Lötmetall einen ersten Schritt aufweist mit Ausfüllen der Durchgangslöcher (4) mit einem Metall mit relativ hohem Schmelzpunkt und einen zweiten Schritt des Ausfüllens der Durchgangslöcher (4) mit einem Metall mit einem relativ geringem Schmelzpunkt.

5. Verfahren zur Herstellung einer integrierten Schaltungschippackung nach Anspruch 1 oder 2,
wobei die Summe der Dicken des ersten Films (5) und des zweiten Films (6) größer ist als die Höhe der Metallanschlüsse.

6. Verfahren zur Herstellung einer integrierten Schaltungschippackung nach Anspruch 1 oder 2,
welches ferner aufweist den Schritt:
Anordnen auf der Oberfläche des IC-Chips (2) gegenüber der ersten Vorderfläche ein Wärmesenketeil (13), wobei die Oberfläche des Wärmesenketeils in nahem Kontakt mit der gegenüberliegenden Oberfläche des IC-Chips (2) ist.

7. Verfahren zur Herstellung einer integrierten Schaltungschippackung nach Anspruch 6, ferner mit dem Schritt vor dem Schritt des Anordnens, Anstreichen der entgegengesetzten Oberflächen mit Thermofett.

8. Verfahren zur Herstellung einer integrierten Schaltungschippackung nach Anspruch 4,
wobei der Aufheizschritt einen Vorheizschritt aufweist zum Schmelzen des Metalls mit niedrigem Schmelzpunkt, und einen Hauptheizschritt zum Schmelzen des Metalls mit hohem Schmelzpunkt, so daß nach der Vollendung des Vorheizschrittes das Multichipmodul auf elektrische Verbindung getestet werden kann.

## Revendications

1. Procédé de fabrication d'un boîtier pour puces de circuit intégré formant un module à puce multiple comprenant les étapes consistant à connecter électriquement une pluralité de puces de circuit intégré (2) à une seule carte de circuit (1) en silicium plate par interconnexion de type protubérance, les dites puces de circuit intégré (2) ayant chacune une pluralité de régions de diffusion d'impuretés à leur surface avant et une pluralité de protubérances métalliques (3) respectivement connectées aux dites régions de diffusion d'impuretés à leur surface avant, la dite seule carte de circuit (1) en silicium plate ayant un motif de câblage (15, 6a), ledit procédé comprenant les étapes consistant à :
former un premier film plat (5) constitué d'un matériau isolant organique sur ladite surface avant des dites puces de circuit intégré (2) jusqu'à une première épaisseur ;
former une pluralité de premiers trous traversants (3b) dans le dit premier film plat (5), formant une pluralité de trajets d'échappement d'air allongés à partir de la dite pluralité des premiers trous traversants (3b) jusqu'à une partie de l'extrémité dudit premier film plat (5), les trous traversants ayant de ce fait des parois discontinues et former les dites protubérances métalliques (3) disposées à l'intérieur desdits trous traversants ;
former un second film plat (6) constitué d'un matériau isolant organique sur une surface de la dite seule carte de circuit en silicium plate (1) jusqu'à une seconde épaisseur ;
former une pluralité de seconds trous traversants (4) dans ledit second film plat (6) ;
remplir ladite pluralité des seconds trous traversants (4) avec de la soudure métallique (4a, 4b, 4c), respectivement ; et
former un adhésif constitué d'un matériau isolant organique thermodurcissable (7) sur la surface en regard du dit premier (5) et/ou du dit second film plat (6) ; et chauffer la dite seule carte de circuit (1) en silicium plate en contact avec lesdites protubérances métalliques (3) formées dans ladite pluralité des premiers trous traversants et ladite soudure métallique formée dans la dite pluralité des seconds trous traversants (4) pour faire fondre ladite soudure métallique et pour thermodurcir ledit adhésif constitué d'un matériau isolant organique thermodurcissable.

2. Procédé selon la revendication 1, dans lequel ledit matériau isolant organique formant ledit premier film (5) et ledit second film (6) est un polyimide thermodurcissable et ledit adhésif est un polyimide avant le thermodurcissement.

3. Procédé selon la revendication 2, dans lequel ledit premier film (5) est plus mince que ledit second film (6).

4. Procédé selon la revendication 1 ou 2, dans lequel ladite étape consistant à remplir lesdits seconds trous traversants (4) avec ladite soudure métallique comprend une première étape consistant à remplir lesdits trous traversants (4) avec un métal à point de fusion relativement haut et une seconde étape consistant à remplir lesdits trous traversants (4) avec du métal à point de fusion relativement bas.

5. Procédé selon la revendication 1 ou 2, dans lequel la somme des épaisseurs dudit premier film (5) et dudit second film (6) est plus grande que la hauteur desdites protubérances métalliques.

6. Procédé selon la revendication 1 ou 2, comprenant de plus l'étape consistant à disposer sur les surfaces desdites puces de circuit intégré (2) opposées à leurs surfaces avant un élément dissipateur thermique (13), une surface dudit élément dissipateur thermique étant en contact intime avec lesdites surfaces opposées desdites puces de circuit intégré(2).

7. Procédé selon la revendication 6, comprenant, de plus, avant l'étape de disposition, l'étape consistant à recouvrir lesdites surfaces opposées avec de la graisse thermique.

8. Procédé selon la revendication 4, dans lequel l'étape de chauffage comprend une étape de préchauffage pour fondre ledit métal à point de fusion bas et une étape de chauffage principale pour fondre ledit métal à point de fusion haut de sorte que, après que l'étape de préchauffage a été achevée, ledit module à puce multiple peut être vérifié en ce qui concerne ses connexions électriques.
